Europäisches Patentamt

European Patent Office

Office européen des brevets

(19)

(11) EP 0 575 587 B1

(12) **EUROPÄISCHE PATENTSCHRIFT**

(45) Veröffentlichungstag und Bekanntmachung des Hinweises auf die Patenterteilung:
**01.04.1998 Patentblatt 1998/14**

(21) Anmeldenummer: **93901643.2**

(22) Anmeldetag: **22.12.1992**

(51) Int Cl.6: **H03K 17/30**, H03K 17/14

(86) Internationale Anmeldenummer:
**PCT/DE92/01077**

(87) Internationale Veröffentlichungsnummer:
**WO 93/14569 (22.07.1993 Gazette 1993/18)**

(54) **SCHALTUNGSANORDUNG ZUR UNTERSPANNUNGSERKENNUNG**

UNDERVOLTAGE DETECTION CIRCUIT

CIRCUIT POUR LA DETECTION DE SOUS-TENSIONS

(84) Benannte Vertragsstaaten:
**DE FR GB IT**

(30) Priorität: **14.01.1992 DE 4200681**

(43) Veröffentlichungstag der Anmeldung:
**29.12.1993 Patentblatt 1993/52**

(73) Patentinhaber: **ROBERT BOSCH GMBH**
**70442 Stuttgart (DE)**

(72) Erfinder: **HILGENBERG, Bernd**
**D-3508 Melsungen (DE)**

(74) Vertreter: **Friedmann, Jürgen, Dr.-Ing. et al**
**Zentralabteilung Patente,**
**Postfach 30 02 20**
**70442 Stuttgart (DE)**

(56) Entgegenhaltungen:
**WO-A-91/15756**      **US-A- 3 702 946**
**US-A- 4 728 815**

• **IBM TECHNICAL DISCLOSURE BULLETIN. Bd. 29, Nr. 5, Oktober 1986, NEW YORK US Seiten 2167 - 2168 'Power-on circuit'**

## Beschreibung

### STAND DER TECHNIK

Die Erfindung betrifft eine Schaltungsanordnung zur Unterspannungserkennung nach der Gattung des unabhängigen Anspruchs.

Zur Unterspannungserkennung sind Komparatoren bekannt, bei denen ein Eingang mit der zu überwachenden Spannung und der andere Eingang mit einer Referenzspannung beaufschlagt ist, wobei der Komparator ein Ausgangssignal erzeugt, wenn die angelegte Spannung die Referenzspannung unterschreitet. Der Nachteil derartiger Schaltungen besteht in einer hohen unteren Funktionsgrenze.

Andere bekannte Schaltungen zur Unterspannungserkennung. welche Flußspannungen (Dioden) als Referenzspannung heranziehen, haben den Nachteil einer stark temperaturabhängigen Schaltschwelle. Für viele Anwendungen, bei denen eine exakte Schwelle eine wichtige Bedingung ist, können diese bekannten Schaltungen daher nicht eingesetzt werden.

Die Druckschrift WO 91/15756 beschreibt eine Schaltungsanordnung zur Unterspannungserkennung gemäß dem Oberbegriff des Anspruchs 1. Dabei ist ein Transistor vorgesehen, der einen Strom liefert, sowie zwei weitere Transistoren, die als Stromspiegel verschaltet sind. Am Emitter des dritten Transistors ist ein Widerstand angeschlossen. Es fließt durch den zweiten Transistor der Strom und durch den dritten Transistor ein weiterer Strom. Ein vierter Transistor schaltet in den gesperrten Zustand, wenn eine Unterspannung erkannt wird.

### VORTEILE DER ERFINDUNG

Die erfindungsgemäße Schaltungsanordung zur Unterspannungserkennung mit den kennzeichnenden Merkmalen des Hauptanspruchs hat demgegenüber den Vorteil eines einfachen und kostengünstigen Aufbaus und besitzt eine exakte Schaltschwelle, wobei mit geringem Aufwand eine Temperaturkompensation der Schaltschwelle oder ein bestimmter gewünschter Temperaturgang dieser Schaltschwelle erreicht werden kann. Eine Funktion ist noch bei sehr kleinen Spannungen von weniger 1 Volt gewährleistet.

Das Ausgangssignal der Schaltungsanordnung wird zweckmäßigerweise über eine zweiten Transistor erzeugt, der vom ersten Transistor bei Unterschreitung des vorgegebenen Spannungswerts entsprechend gesteuert wird.

Erfindungsgemäß ist der Emitter des ersten Transistors mit einem ersten Pol der zu überwachenden Spannung verbunden, wobei in dessen Kollektorkreis wenigstens ein Widerstand geschaltet und mit dem zweiten Pol der zu überwachenden Spannung verbunden ist.

Eine besonders exakte Temperaturkompensation der Schaltschwelle oder ein genau vorbestimmter Temperaturgang dieser Schaltschwelle kann dadurch erreicht werden, daß der Abgriff der Reihenschaltung der Schaltmittel über einen Kompensationswiderstand mit dem ersten Pol der zu überwachenden Spannung verbunden ist. Dieser Kompensationswiderstand weist im einen Falle einen die Schaltschwelle im wesentlichen unabhängig von der Temperatur machenden Widerstandswert und im anderen Falle einen der Schaltschwelle eine vorgebbare Temperaturabhängigkeit gebenden Widerstandswert auf.

Durch die in den abhängigen Ansprüchen aufgeführten Maßnahmen sind vorteilhafte Weiterbildungen und Verbesserungen der im Hauptanspruch angegebenen Schaltungsanordnung möglich.

Ein wesentlicher Beitrag zur Temperaturkompensation der Schaltschwelle wird dadurch erreicht, daß der erste Transistor zusammen mit dem als Diode der Schaltmittel geschalteten Transistor als Stromspiegel mit Temperaturkompensations-Widerstand geschaltet ist.

Um die Schaltschwelle im wesentlichen unabhängig von der Temperatur zu machen, entspricht der Widerstandswert des Kompensationswiderstands im wesentlichen dem des Widerstands im Kollektorkreis des ersten Transistors multipliziert mit einem Faktor a, und der Widerstandswert des Widerstands zwischen dem Abgriff der Reihenschaltung und dem zweiten Pol der zu überwachenden Spannung entspricht im wesentlichen dem des Widerstands im Kollektorkreis des ersten Transistors multipliziert mit dem Faktor b, wobei diese Faktoren im Anspruch 4 und in der Beschreibung näher angegeben sind.

Ein weiterer Beitrag zur Temperaturkompensation der Schaltschwelle besteht darin, daß der zweite Transistor einen Widerstand im Kollektorkreis aufweist, dessen Widerstandswert dem des Witerstands im Kollektorkreis des ersten Transistors entspricht, und daß der zweite Transistor im wesentlichen dem ersten Transistor entspricht. Anstelle dieses Widerstands kann zur günstigeren Integration der Schaltung auch ein Transistor treten, der zusammen mit einem weiteren als Diode geschalteten Transistor einen Stromspiegel bildet.

### ZEICHNUNG

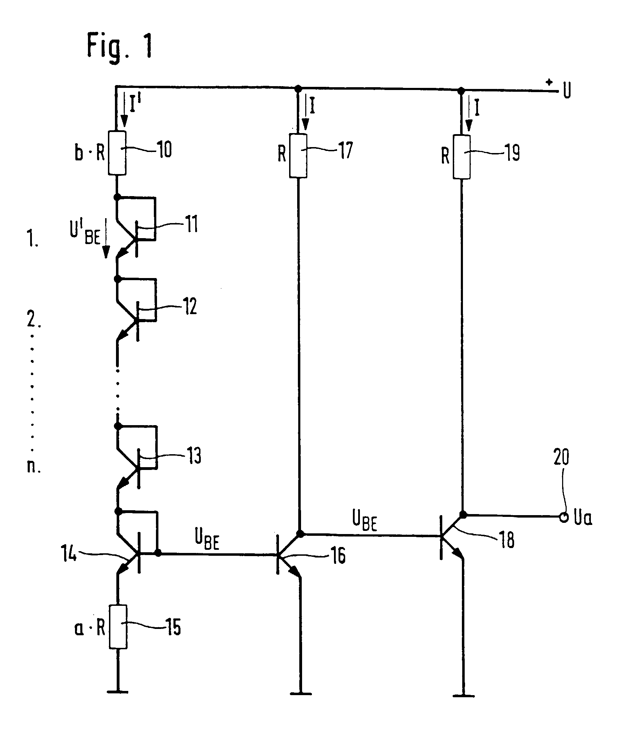

Drei Ausführungsbeispiele der Erfindung sind in der Zeichnung dargestellt und in der nachfolgenden Beschreibung näher erläutert. Die Fig. 1 bis 3 zeigen Schaltbilder von Schaltungsanordnungen zur Unterspannungserkennung gemäß den drei Ausführungsbeispielen.

### BESCHREIBUNG DER AUSFÜHRUNGSBEISPIELE

Bei dem in Fig. 1 dargestellten ersten Ausführungsbeispiel ist eine zu überwachende Spannung U an eine Reihenschaltung angelegt, die aus einem Widerstand 10, n-Dioden 11,12,13, einer weiteren Diode 14 und einem Widerstand 15 besteht. Von den n-Dioden sind nur die erste Diode 11, die zweite Diode 12 und die n. Diode 13 dargestellt. Als Dioden sind Transistoren in Diodenschaltung eingesetzt, das heißt Transistoren, bei denen jeweils die Basis mit dem Kollektor verbunden ist. Die als Dioden 11,12,13,14 verwendeten Transistoren sind jeweils als npn-Transistoren ausgebildet.

Die Basis der weiteren Diode 14 (Transistor in Diodenschaltung) ist mit der Basis eines ersten Transistors 16 verbunden, dessen Emitter an Masse bzw. an den negativen Pol der Spannung U und dessen Kollektor über einen Widerstand 17 an den positiven Pol dieser Spannung U angeschlossen ist. Da die Basis der als Transistor ausgebildeten weiteren Diode 14 mit dem Kollektor verbunden ist, bildet diese weitere Diode 14 zusammen mit dem ersten Transistor 16 einen sogenannten Stromspiegel, wie er beispielsweise in dem Fachbuch "Halbleiter-Schaltungstechnik", U. Tietze, Ch. Schenk, Springer-Verlag, 7. Aufl. 1985, S. 62 ff., näher beschrieben ist, allerdings nicht in Verbindung mit einer Unterspannungserkennung oder einer Dioden-Reihenschaltung.

Der Kollektor des ersten Transistors 16 ist mit der Basis eines zweiten Transistors 18 verbunden, der wie der erste Transistor 16 ebenfalls als npn-Transistor ausgebildet ist. Sein Emitter liegt an Masse, und sein Kollektor ist über einen Widerstand 19 an den positiven Pol der Spannung U angeschlossen. Der Kollektor des zweiten Transistors 18 ist weiterhin mit einer Ausgangsklemme 20 verbunden, an der das Ausgangssignal $U_a$ dieser Schaltungsanordnung zur Unterspannungserkennung anliegt.

Wesentlich für die Temperaturkompensation der Schaltschwelle ist der Widerstand 15, der einen $U_T = k \cdot T/e$ proportionalen Term erzeugt, der das Temperaturverhalten der Basis-Emitter-Spannung $U_{BE}$ der Dioden 11-13 je nach Widerstandswert kompensiert. Die Wahl des Widerstandswerts des Widerstands 15 ist von den Widerstandswerten der Widerstände 10 und 17, von der Spannung U, der Zahl n der Dioden 11 bis 13 und von der Emitterzahl der als Transistor ausgebildeten Diode 14 abhängig. Für die Berechnung wird den Widerständen 17 und 19 der Wert R, dem Widerstand 10 der Wert b . R und dem Widerstand 15 der Wert a . R zugewiesen. Durch die Kollektorleitungen der Transistoren 16 und 18 fließe der Strom I und durch die Reihenschaltung der Dioden 11 bis 14 der Strom I'. Unter Verwendung der vier folgenden Gleichungen (1) bis (4):

$$R \cdot I = b \cdot R \cdot I' + n \cdot U'_{BE} \qquad (1)$$

$$U_{BE} = a \cdot R \cdot I' + U'_{BE} \qquad (2)$$

$$R \cdot I = U - U_{BE} \qquad (3)$$

$$U_{BE} = U_T \cdot \ln \frac{U - U_{BE}}{R \cdot I_{SAT}} \qquad (4)$$

führt dies zu den folgenden Faktoren a und b:

$$a = \frac{x \cdot U_T}{U - U_{BE}} \exp(x)$$

$$b = \frac{n \cdot x \cdot U_T + U - (n+1) \cdot U_{BE}}{U - U_{BE}} \exp(x)$$

Die Herleitung erfolgte für den Schaltpunkt unter der Voraussetzung einer vollständigen Temperaturkompensation. Die einzelnen dabei verwendeten Größen sind nachstehend aufgelistet:

$$x = \frac{n \cdot U}{U - U_{BE}} \cdot \frac{U_{Gap} - U_{BE}}{U - (n+1) U_{Gap}}$$

n = Zahl der Dioden,

U = zu überwachende Spannung,

$I_{SAT}$ = Sperrsättigungsstrom,

$U_{BE}$ = Basis-Emitter-Spannung (ca. 0,75 V),

$U_T = \frac{k \cdot T}{e}$ (temperaturproportionaler Term)

k = Boltzmannsche Konstante,

T = Temperatur

e = Elementarladung und

$U_{Gap}$ = Bandgap-Spannung der Dioden (ca. 1,24 V).

Für die Bandgap-Spannung $U_{Gap}$ kann in erster Näherung die Bandgap-Spannung von Silizium von ca. 1,24 Volt und für die Basis-Emitter-Spannung $U_{BE}$ der Wert 0,75 Volt eingesetzt werden. Sind genauere Werte erforderlich, so kann der Wert von $U_{BE}$ beispielsweise durch ein Iterationsverfahren aus der Gleichung (4) bestimmt werden. Experimentelle Methoden zur Ermittlung dieser Spannungen sind selbstverständlich ebenfalls möglich.

Der Temperaturkoeffizient und die Absolut-Streuungen der Widerstände gehen nur relativ wenig in das angegebene Ergebnis ein, sofern die relativen Größen a und b exakt sind.

Ein Zahlenbeispiel soll zur Verdeutlichung der ermittelten Ergebnisse dienen. Dabei wird von folgenden Zahlenwerten ausgegangen: $U = 4$ V, $U_{Gap} = 1,24$ V und $U_{BE} = 0,75$ V. Es sei nur eine Diode 11 eingesetzt. Dies führt beim Einsetzen in die vorstehenden Gleichungen zu einem Wert $x = 0,4$, zu einem Wert $a = 0,0048$ und zu einem Wert von $b = 1,16$. Weisen also die Widerstände 17 und 19 beispielsweise den Wert von 10 kOhm auf, dann ergibt sich für den Widerstand 10 ein Wert von 11,6 kOhm und für den Widerstand 15 ein Wert von 48 Ohm.

Es ist selbstverständlich auch möglich, nicht eine vollständig temperaturkompensierte Unterspannungs-Schaltschwelle anzustreben, sondern eine Schaltschwelle, die eine bestimmte vorgebbare Temperaturabhängigkeit aufweist. Auch dies kann durch entsprechende Variation des Widerstands 15 bzw. des Widerstands 10 im Verhältnis zum Widerstand 17 erreicht werden.

Die zwei Transistoren 16,18 sowie die als Dioden 11-14 eingesetzen Transistoren sind zweckmäßigerweise vom selben Typ, so daß auch eine sehr einfache Integration der Schaltung möglich ist. Die Spannung $U_{BE}$ ist daher an jedem Transistor 16,18 dieselbe, wie dies in der Zeichnung dargestellt ist. Selbstverständlich können jedoch prinzipiell auch verschiedene Transistortypen eingesetzt werden sowie andere Realisierungsmöglichkeiten für Dioden.

Beim dargestellten Ausführungsbeispiel besteht die Wirkungsweise darin, daß bei genügend großer Spannung U die Diode 14 und damit auch der Transistor 16 stromleitend sind. Dadurch ist der Transistor 18 gesperrt, und an der Ausgangsklemme 20 liegt eine Signalspannung $U_a$ an, die eine ausreichend große Spannung U kennzeichnet. Sinkt die Spannung U unter einen bestimmten Wert ab, der von der Zahl der Dioden 11-14 und von deren Spannung $U_{BE}$ abhängt, so reicht diese Spannung nicht mehr aus, um alle Dioden durchzusteuern. Die Diode 14 und damit auch der Transistor 16 sperren, und der Transistor 18 wird stromleitend. Die Ausgangsspannung $U_a$ wird dadurch nach Masse gezogen, wodurch das Unterschreiten der Unterspannungsschwelle kenntlich gemacht wird.

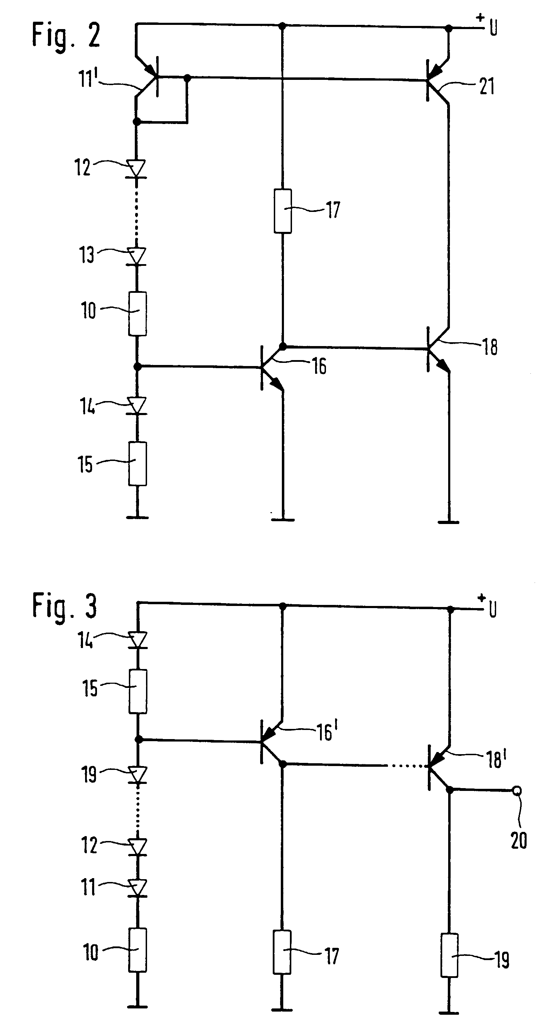

Das in Fig. 2 dargestellte zweite Ausführungsbeispiel entspricht weitgehend dem ersten Ausführungsbeispiel, und gleiche oder gleich wirkende Bauteile sind mit denselben Bezugszeichen versehen und nicht nochmals beschrieben. Die Dioden 12-14 sind jetzt als einfache Dioden und nicht mehr als Transistoren in Diodenschaltung dargestellt. Anstelle der Diode 11 tritt nunmehr die Diode 11', die als pnp-Transistor in Diodenschaltung ausgebildet ist. Anstelle des Widerstands 19 tritt ein pnp-Transistor 21, der zusammen mit der Diode 11' einen Stromspiegel bildet. Hierdurch kann der Widerstand 19 entfallen, was für die Integration von Vorteil ist. Die übrigen Dioden 12-14 können als einfache Dioden oder als Transistoren in Diodenschaltung verwendet werden, wobei hierfür npn-Transistoren gemäß Fig.

1 oder pnp-Transistoren gemäß Fig. 2 verwenden werden können. Soll die Diode 14 mit dem Transistor 16 einen Stromspiegel bilden, so sind selbstverständlich Transistoren vom gleichen Leitfähigkeitstyp erforderlich. Der Widerstand 10 ist jetzt an einer anderen Stelle zwischen dem Abgriff durch die Basis des Transistors 16 und dem positiven Pol der Versorgungsspannung angeordnet. Dies soll zeigen, daß seine Position in der Reihenschaltung ohne Bedeutung ist. Dasselbe gilt auch für den Widerstand 15, dessen Reihenanordnung zur Diode 14 auch vertauscht sein kann.

Um zusätzliche Freiheitsgrade zu bekommen, können auch Transistoren mit mehreren Emittern eingesetzt werden. Sie müssen lediglich ein gleichartiges Temperaturverhalten aufweisen. So kann z.B. durch Erhöhung der Emitterzahl des Transistors 16 der Widerstand 17 verkleinert werden.

Bei dem in Fig. 3 dargestellten dritten Ausführungsbeispiel sind gegenüber Fig. 1 die npn-Transistoren 16 und 18 durch pnp-Transistoren 16' und 18' ersetzt. Deren Emitter liegen demzufolge am positiven Pol der Versorgungsspannung, und die Kollektoren sind über die Widerstände 17 bzw. 19 an Masse angeschlossen. Die Reihenschaltung der Diode 14 mit dem Widerstand 15 liegt wiederum zwischen Basis und Emitter des Transistors 16', und die Reihenschaltung der Dioden 11-13 mit dem Widerstand 10 ist zwischen die Basis dieses Transistors 16' und Masse geschaltet. Zur Vereinfachung der Integration sind die Dioden 11-14 zweckmäßigerweise ebenfalls vom pnp-Typ. Die gestrichelt dargestellte Verbindung zur Basis des zweiten Transistors 18' soll andeuten, daß noch weitere zusätzliche Transistorstufen vorgesehen sein können.

**Patentansprüche**

1. Schaltungsanordnung zur Unterspannungserkennung, mit bei Unterschreitung eines vorgebbaren Spannungswerts schaltenden Schaltmitteln, durch deren Signal wenigstens ein mit diesen Schaltmitteln verbundener Halbleiterschalter (16, 18; 16', 18') steuerbar ist und die als von der zu überwachenden Spannung (U) beaufschlagte Reihenschaltung einer Mehrzahl von Dioden (11-14) mit wenigstens einem Widerstand (10, 15) ausgebildet sind, wobei der Halbleiterschalter (16, 18; 16', 18') wenigstens einen ersten Transistor (16, 16') aufweist, dessen Basis mit einem Abgriff der Reihenschaltung der Schaltmittel verbunden ist, wobei wenigstens eine Diode (14) der Reihenschaltung zwischen der Basis und dem Emitter des ersten Transistors (16; 16') geschaltet ist und der erste Transistor (16; 16') einen zweiten, ein die Unterschreitung des vorgebbaren Spannungswerts einzeigendes Ausgangssignal ($U_a$) erzeugenden Transistor (18; 18') steuert, wobei die Basis des zweiten Transistors (18) mit dem Kollektor des ersten Transistors und der Emitter des zweiten Transistors mit einem ersten Pol der zu überwachenden Spannung verbunden ist, wobei durch die Zahl der Dioden (11-14) und den Widerstandswert des Widerstands (10, 15) der vorgebbare Spannungswert festlegbar ist, wobei zwischen dem Abgriff der Reihenschaltung und dem zweiten Pol der zu überwachenden Spannung wenigstens ein Widerstand (10) in der Reihenschaltung geschaltet ist, dadurch gekennzeichnet, daß zwischen dem Abgriff der Reihenschaltung und dem ersten Pol wenigstens ein Kompensationswiderstand (15) in der Reihenschaltung geschaltet ist, daß der Emitter des ersten Transistors (16; 16') mit dem ersten Pol der zu überwachenden Spannung (U) verbunden ist, wobei in dessen Kollektorleitung wenigstens ein Widerstand (17) geschaltet und mit dem zweiten Pol der zu überwachenden Spannung verbunden ist.

2. Schaltungsanordnung nach Anspruch 1, dadurch gekennzeichnet, daß der erste Transistor (16) zusammen mit einem als Diode (14) der Schaltmittel geschalteten Transistor als Stromspiegel geschaltet ist.

3. Schaltungsanordnung nach Anspruch 1 oder 2, dadurch gekennzeichnet, daß der Kompensationswiderstand (15) einen die Schaltschwelle im wesentlichen unabhängig von der Temperatur machenden Widerstandwert aufweist.

4. Schaltungsanordnung nach Anspruch 3, dadurch gekennzeichnet, daß der Widerstandswert des Kompensationswiderstands (15) im wesentlichen dem des Widerstands (17) in der Kollektorleitung des ersten Transistors (16;16') multipliziert mit einem Faktor a, und der Widerstandswert des Widerstands (10) zwischen dem Abgriff der Reihenschaltung und dem zweiten Pol der zu überwachenden Spannung im wesentlichen dem des Widerstands (17) in der Kollektorleitung des ersten Transistors (16;16') multipliziert mit einem Faktor b entspricht, wobei

$$a = \frac{x \cdot U_T}{U - U_{BE}} \, \exp(x)$$

und

$$b = \frac{n \cdot x \cdot U_T + U - (n + 1) \cdot U_{BE}}{U - U_{BE}} \, \exp(x)$$

ist, bei

$$x = \frac{n \cdot U}{U - U_{BE}} \cdot \frac{U_{Gap} - U_{BE}}{U - (n+1) \, U_{Gap}}$$

n =     Zahl der Dioden,

U =     zu überwachende Spannung,

$U_{BE}$ =     Basis-Emitter-Spannung (ca. 0,75 V),

$$U_T = \frac{k \cdot T}{e} \text{ (temperaturproportionaler Term)}$$

k =     Boltzmannsche Konstante,

T =     Temperatur,

e =     Elementarladung und

$U_{Gap}$ =     Bandgap-Spannung der Dioden (ca. 1,24 V).

5. Schaltungsanordnung nach Anspruch 1 oder 2, dadurch gekennzeichnet, daß der Kompensationswiderstand (15) einen der Schaltschwelle eine vorgebbare Temperaturabhängigkeit gebenden Widerstandswert aufweist.

6. Schaltungsansordnung nach einem der vorhergehenden Ansprüche, dadurch gekennzeichnet, daß der zweite Transistor (18,18') einen Widerstand (19) in der Kollektorleitung aufweist, dessen Widerstandswert dem des Widerstands (17) im Kollektorkreis des ersten Transistors (16,16') entspricht, und daß der zweite Transistor (18,18') im wesentlichen dem ersten Transistor (16,16') entspricht.

7. Schaltungsanordnung nach einem der Ansprüche 1 bis 5, dadurch gekennzeichnet, daß in der Kollektorleitung des zweiten Transistors (18) die Schaltstrecke eines weiteren Transistors (21) vorgesehen ist, der zusammen mit einem weiteren als Diode (11') der Schaltmittel geschalteten Transistor einen Stromspiegel bildet, wobei die Diode (11') an den zweiten Pol der zu überwachenden Spannung angeschlossen ist.

8. Schaltungsanordnung nach einem der vorhergehenden Ansprüche, dadurch gekennzeichnet, daß die Dioden (11-14;11') als Transistoren in Diodenschaltung ausgebildet sind.

9. Schaltungsanordnung nach Anspruch 8, dadurch gekennzeichnet, daß die als Dioden (11-14) verwendeten Transistoren vom gleichen Typ wie die übrigen verwendeten Transistoren (16,16; 18,18') sind.

## Claims

1. Circuit arrangement for undervoltage detection, having switching means which switch when a voltage value falls below a predeterminable voltage value, it being possible to control at least one semiconductor switch (16, 18; 16', 18') which is connected to these switching means by the signal of the latter, and the switching means being designed as a series circuit formed by a plurality of diodes (11-14) with at least one resistor (10, 15), to which series circuit the voltage (U) to be monitored is applied, the semiconductor switch (16, 18; 16', 18') having at least one first transistor (16, 16'), whose base is connected to a tap of the series circuit of the switching means, at least one diode (14) of the series circuit being connected between the base and the emitter of the first transistor (16; 16') and the first transistor (16; 16') controlling a second transistor (18; 18'), which generates an output signal ($U_a$) indicating that the voltage value has fallen below the predeterminable voltage value, the base of the second transistor (18) being connected to the collector of the first transistor and the emitter of the second transistor being connected to a first pole of the voltage to be monitored, it being possible to define the predeterminable voltage value by the number of diodes (11-14) and the resistance of the resistor (10, 15), at least one resistor (10) in the series circuit being connected between the tap of the series circuit and the second pole of the voltage to be monitored, characterized in that at least one compensation resistor (15) in the series circuit is connected between the tap of the series circuit and the first pole, in that the emitter of the first transistor (16; 16') is connected to the first pole of the voltage (U) to be monitored, at least one resistor (17) being connected into the collector lead of the said transistor and being connected to the second pole of the voltage to be monitored.

2. Circuit arrangement according to Claim 1, characterized in that the first transistor (16), together with a transistor which is connected as diode (14) of the switching means, is connected as a current mirror.

3. Circuit arrangement according to Claim 1 or 2, characterized in that the compensation resistor (15) has a resistance which makes the switching threshold essentially independent of the temperature.

4. Circuit arrangement according to Claim 3, characterized in that the resistance of the compensation resistor (15) essentially corresponds to that of the resistor (17) in the collector lead of the first transistor (16; 16') multiplied by a factor a, and the resistance of the resistor (10) between the tap of the series circuit and the second pole of the voltage to be monitored essentially corresponds to that of the resistor (17) in the collector lead of the first transistor (16; 16') multiplied by a factor b, where

$$a = \frac{x \cdot U_T}{U - U_{BE}} \exp{(x)}$$

and

$$b = \frac{n \cdot x \cdot U_T + U - (n + 1) \cdot U_{BE}}{U - U_{BE}} \exp{(x)},$$

where

$$x = \frac{n \cdot U}{U - U_{BE}} \cdot \frac{U_{Gap} - U_{BE}}{U - (n+1) U_{Gap}}$$

n = number of diodes,
U = voltage to be monitored,
$U_{BE}$ = base-emitter voltage (approx. 0.75 V),

$$U_T = \frac{k \cdot T}{e} \text{ (temperature-proportional term)}$$

k = Boltzmann's constant,
T = temperature,
e = elementary charge and
$U_{Gap}$ = bandgap voltage of the diodes (approx. 1.24 V).

5. Circuit arrangement according to Claim 1 or 2, characterized in that the compensation resistor (15) has a resistance which imparts a predeterminable temperature dependence to the switching threshold.

6. Circuit arrangement according to one of the preceding claims, characterized in that the second transistor (18, 18') has a resistor (19) in the collector lead, the resistance of which resistor corresponds to that of the resistor (17) in the collector circuit of the first transistor (16, 16'), and in that the second transistor (18, 18') essentially corresponds to the first transistor (16, 16').

7. Circuit arrangement according to one of Claims 1 to 5, characterized in that the switching path of a further transistor (21) is provided in the collector lead of the second transistor (18), which further transistor, together with a further transistor which is connected as diode (11') of the switching means, forms a current mirror, the diode (11') being connected to the second pole of the voltage to be monitored.

8. Circuit arrangement according to one of the preceding claims, characterized in that the diodes (11-14; 11') are designed as transistors in a diode connection.

9. Circuit arrangement according to Claim 8, characterized in that the transistors used as diodes (11-14) are of the same type as the rest of the transistors (16, 16'; 18, 18') used.

## Revendications

1. Circuit de détection d'une sous-tension comprenant :

   - des moyens de commutation qui, en cas de dépassement vers le bas d'une tension prédéterminée, commandent par leur signal, au moins un commutateur à semi-conducteurs (16, 18 ; 16', 18') reliés a ces moyens de commutation,
   - les moyens de commutation sont réalisés par le montage en série de nombreuses diodes (11-14) avec au moins une résistance (10, 15), ce montage en série recevant la tension à surveiller (U),
   - le commutateur à semi-conducteurs (16, 18 ; 16', 18') comprenant au moins un premier transistor (16, 16') dont la base est reliée à une prise du montage en série des moyens de commutation,
   - au moins une diode (14) du montage en série est branchée entre la base et l'émetteur du premier transistor (16, 16'),
   - le premier transistor (16, 16') commandant un second transistor (18, 18') qui génère un signal de sortie ($U_a$) indiquant le dépassement vers le bas de la tension prédéterminée,
   - la base du second transistor (18) étant reliée au collecteur du premier transistor et l'émetteur du second transistor au premier pôle de la tension à surveiller,
   - le nombre des diodes (11, 14) et la valeur de la résistance (10, 15) fixant la valeur de la tension prédéterminée,
   - entre la prise du montage en série et le second pôle de la tension à surveiller, il y a au moins une résistance (10) dans le montage en série,

   caractérisé en ce qu'

   - entre la prise du montage en série et le premier pôle, il y a au moins une résistance de compensation (15) dans le montage en série,
   - l'émetteur du premier transistor (16, 16') est relié au premier pôle de la tension (U) à surveiller,
   - son collecteur étant relié à au moins une résistance (17) reliée au second pâle de la tension à surveiller.

2. Circuit selon la revendication 1, caractérisé en ce que le premier transistor (16) forme un miroir de courant avec un transistor branché comme diode (14) des moyens de commutation.

3. Circuit selon la revendication 1 ou 2, caractérisé en ce que la résistance de compensation (15) a une valeur de résistance qui rend le seuil de commutation pratiquement indépendant de la température.

4. Circuit selon la revendication 3, caractérisé en ce que la valeur de la résistance de compensation (15) correspond principalement à celle de la résistance (17) du branchement du collecteur du premier transistor (16, 16'), multipliée par un coefficient (a) et la valeur de la résistance (10) entre la prise du montage en série et le second pôle de la tension à surveiller correspond essentiellement à celle de la résistance (17) dans le branchement du collecteur du premier transistor (16, 16') multipliée par un coefficient (b), avec

$$a = \frac{x \cdot U_T}{U \cdot U_{BE}} \exp(x)$$

$$b = \frac{n \cdot x \cdot U_T + U - (n+1) \cdot U_{BE}}{U - U_{BE}} \exp(x)$$

$$x = \frac{n \cdot U}{U - U_{BE}} \cdot \frac{U_{Gap} - U_{BE}}{U - (n+1) U_{Gap}}$$

n = Nombre de diodes,
U = Tension à surveiller
$U_{BE}$ = Tension base-émetteur (environ 0,75 V)

$U_T = \dfrac{k \cdot T}{e}$ (terme proportionnel à la température)

k = Constante de Boltzmann
T = Température
e = Charge élémentaire
$U_{Gap}$ = Tension de l'intervalle de bande pour les diodes (environ 1,24 V).

5. Circuit selon la revendication 1 ou 2, caractérisé en ce que la résistance de compensation (15) présente une valeur de résistance donnant au seuil de commutation une fonction prédéterminée de la température.

6. Circuit selon l'une des revendications précédentes, caractérisé en ce que

- le second transistor (18, 18') comporte une résistance (19) reliée au branchement du collecteur et dont la valeur de résistance correspond à celle de la résistance (17) du circuit du collecteur du premier transistor (16, 16') et,
- le second transistor (18, 18') correspond essentiellement au premier transistor (16, 16').

7. Circuit selon l'une des revendications 1 à 5, caractérisé en ce que
le branchement du collecteur du second transistor (18) est relié au chemin de commutation d'un autre transistor (21) formant un miroir de courant avec un autre transistor de commutation branché comme diode (11'), la diode (11') étant reliée au second pôle de la tension à surveiller.

8. Circuit selon l'une des revendications précédentes, caractérisé en ce que
les diodes (11-14 ; 11') sont formées par des transistors branchés comme des diodes.

9. Circuit selon la revendication 8, caractérisé en ce que
les transistors utilisés comme des diodes (11-14) sont de même type que les autres transistors (16, 16' 18, 18'), utilisés.

## Fig. 1

Fig. 2

Fig. 3